# EUROPEAN PATENT APPLICATION

(11) **EP 4 741 995 A1**
(43) Date of publication of application: **13.05.2026**
(21) Application number: 24854029.6
(22) Date of filing: 29.01.2024
(51) Int. Cl.: G06F 1/20, H01L 23/44, H05K 7/20

(54) **LIQUID IMMERSION COOLING DEVICE AND CONTROL METHOD THEREFOR**

(30) Priority: 17.08.2023 JP 2023132923
(71) Applicant: Mitsubishi Heavy Industries, Ltd., Tokyo 100-8332 (JP)
(72) Inventor: INOUE, Naoki, Tokyo 100-8332 (JP); KAJITANI, Fumito, Tokyo 100-8332 (JP); MATSUDA, Naohiko, Tokyo 100-8332 (JP)
(74) Representative: Studio Torta S.p.A.
(86) International application number: PCT/JP2024/002573
(87) International publication number: WO 2025/037435

(57) **Abstract**

Provided is a liquid immersion cooling device capable of dealing with equipment troubles in a cooling system of cooling liquid. A liquid immersion cooling device (1) includes: radiators (11) that cool cooling water by exchanging heat with outside air; CDUs (7) where the cooling water cooled by the radiators (11) is introduced and exchanges heat with cooling liquid; a cooling water circulation system in which the cooling water is circuited between the radiators (11) and the CDUs (7); liquid immersion containers (5) into which the cooling liquid cooled by the CDUs (7) are introduced and which retain therein cooling liquid for immersing and cooling electronic equipment; and a cooling liquid circulation system (9) in which cooling liquid is circulated between the CDUs (7) and the liquid immersion containers (5). The radiators (11), the CDUs (7), the cooling water circulation system, the liquid immersion containers (5), and the cooling liquid circulation system (9) are provided in a plurality of parallel arrangements.

## Description

### Technical Field

For example, the present disclosure relates to a liquid immersion cooling device suitably used for cooling a server in a data center, and a control method therefor.

### Background Art

PTL 1 discloses that electronic equipment such as a server and a storage in a data center is immersed and cooled in a cooling liquid.

### Citation List

### Patent Literature

[PTL 1] Japanese Patent No. 6658312

### Summary of Invention

### Technical Problem

However, in a liquid immersion cooling system disclosed in PTL 1, a cooling system of the cooling liquid is a single system. When equipment troubles occur in the cooling system of the cooling liquid, the cooling liquid generates heat, thereby causing a possibility that the server is stopped.

In addition, in the data center, it is required to reduce power usage effectiveness (PUE: total power consumption of a facility/power consumption of IT equipment), which is an index indicating power usage efficiency. In order to reduce the PUE, it is necessary to optimize an operation of the cooling system. However, a liquid immersion-type data center has little operation record, and means for optimizing an operation method is not defined. For example, in a method of performing feedback control while a target temperature of the liquid immersion cooling device is set as one target point, adjustment parameters (such as a refrigerant flow rate and a rotation speed of a fan) are diverse, an equipment configuration of a control system is complicated, thereby causing a possibility of increasing probability of control troubles.

The present disclosure has been made in view of these circumstances, and an object of the present disclosure is to provide a liquid immersion cooling device and a control method therefor which can cope with equipment troubles in a cooling system of a cooling liquid.

In addition, an object of the present disclosure is to provide a liquid immersion cooling device and a control method therefor which can easily control a target temperature of a liquid immersion cooling device.

### Solution to Problem

According to an aspect of the present disclosure, there is provided a liquid immersion cooling device including a radiator that cools cooling water by exchanging heat with outside air, a liquid immersion heat exchanger to which the cooling water cooled by the radiator is guided to exchange the heat with a cooling liquid, a cooling water circulation system in which the cooling water is circulated between the radiator and the liquid immersion heat exchanger, a liquid immersion container to which the cooling liquid cooled by the liquid immersion heat exchanger is guided and in which the cooling liquid for immersing and cooling electronic equipment is stored, and a cooling liquid circulation system in which the cooling liquid is circulated between the liquid immersion heat exchanger and the liquid immersion container. A plurality of the radiators, and/or a plurality of the liquid immersion heat exchangers, and/or a plurality of the cooling water circulation systems, and/or a plurality of the liquid immersion containers, and/or a plurality of the cooling liquid circulation systems are provided in parallel.

According to an aspect of the present disclosure, there is provided a liquid immersion cooling device including a radiator that cools cooling water by exchanging heat with outside air, a liquid immersion heat exchanger to which the cooling water cooled by the radiator is guided to exchange the heat with a cooling liquid, a cooling water circulation system in which the cooling water is circulated between the radiator and the liquid immersion heat exchanger, a liquid immersion container to which the cooling liquid cooled by the liquid immersion heat exchanger is guided and in which the cooling liquid for immersing and cooling electronic equipment is stored, and a cooling liquid circulation system in which the cooling liquid is circulated between the liquid immersion heat exchanger and the liquid immersion container. A plurality of the radiators and a plurality of the liquid immersion heat exchangers are provided in parallel. The liquid immersion cooling device further includes a control unit that has a control map in which the number of the radiators to be used and the number of the liquid immersion heat exchangers to be used are represented on a map when an outside air temperature is set as a first axis and a calorific value of the electronic equipment to be cooled is set as a second axis, and that determines the number of the radiators to be used and the number of the liquid immersion heat exchangers to be used, from the control map, based on the outside air temperature and the calorific value of the electronic equipment during an operation.

According to an aspect of the present disclosure, there is provided a control method for a liquid immersion cooling device including a radiator that cools cooling water by exchanging heat with outside air, a liquid immersion heat exchanger to which the cooling water cooled by the radiator is guided to exchange the heat with a cooling liquid, a cooling water circulation system in which the cooling water is circulated between the radiator and the liquid immersion heat exchanger, a liquid immersion container to which the cooling liquid cooled by the liquid immersion heat exchanger is guided and in which the cooling liquid for immersing and cooling electronic equipment is stored, and a cooling liquid circulation system in which the cooling liquid is circulated between the liquid immersion heat exchanger and the liquid immersion container, in which a plurality of the radiators, and/or a plurality of the liquid immersion heat exchangers, and/or a plurality of the cooling water circulation systems, and/or a plurality of the liquid immersion containers, and/or a plurality of the cooling liquid circulation systems are provided in parallel. The control method includes switching between the radiators, and/or the liquid immersion heat exchangers, and/or the cooling water circulation systems, and/or the liquid immersion containers, and/or the cooling liquid circulation systems.

According to an aspect of the present disclosure, there is provided a control method for a liquid immersion cooling device including a radiator that cools cooling water by exchanging heat with outside air, a liquid immersion heat exchanger to which the cooling water cooled by the radiator is guided to exchange the heat with a cooling liquid, a cooling water circulation system in which the cooling water is circulated between the radiator and the liquid immersion heat exchanger, a liquid immersion container to which the cooling liquid cooled by the liquid immersion heat exchanger is guided and in which the cooling liquid for immersing and cooling electronic equipment is stored, and a cooling liquid circulation system in which the cooling liquid is circulated between the liquid immersion heat exchanger and the liquid immersion container, in which a plurality of the radiators and a plurality of the liquid immersion heat exchangers are provided in parallel. The control method includes preparing a control map in which the number of the radiators to be used and the number of the liquid immersion heat exchangers to be used are represented on a map when an outside air temperature is set as a first axis and a calorific value of the electronic equipment to be cooled is set as a second axis, and determining the number of the radiators to be used and the number of the liquid immersion heat exchangers to be used, from the control map, based on the outside air temperature and the calorific value of the electronic equipment during an operation.

### Advantageous Effects of Invention

It is possible to cope with equipment troubles of a cooling system of a cooling liquid. In addition, a target temperature of a liquid immersion cooling device can be easily controlled.

### Brief Description of Drawings

FIG. 1 is a schematic diagram showing a schematic configuration of a liquid immersion cooling device.
FIG. 2 is a perspective view showing a state where a free cooling device is placed on a common installation panel.
FIG. 3 is a diagram showing an outline of map control.
FIG. 4A is a control map of the number of radiators and the number of CDUs.
FIG. 4B is a control map of a rotation speed of a fan.
FIG. 4C is a control map of a flow rate of a cooling water pump.
FIG. 4D is a control map of a flow rate of a radiator pump.
FIG. 4E is a control map of a flow rate of a cooling liquid pump.
FIG. 4F is a control map of switching times of a radiator, a cooling water outlet pipe, and a cooling water inlet pipe.

### Description of Embodiments

Hereinafter, embodiments according to the present disclosure will be described with reference to the drawings.

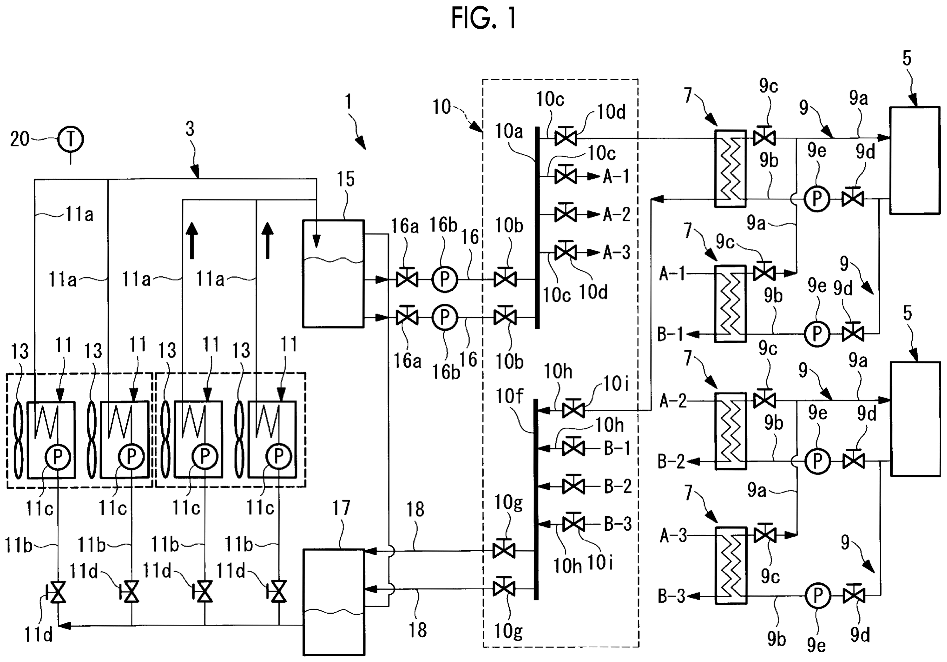

FIG. 1 shows a schematic configuration of a liquid immersion cooling device 1 used in a liquid immersion-type data center. The liquid immersion cooling device 1 includes a liquid immersion container 5, a free cooling device 3, and a CDU (liquid immersion heat exchanger) 7.

The liquid immersion container 5 is a bottomed container that internally stores a cooling liquid. As the cooling liquid, a liquid having electrical insulation is used, and, for example, silicone-based oil or the like is used. The liquid immersion container 5 is filled with the cooling liquid to reach a height to such an extent that all of a plurality of substrates (electronic equipment) disposed inside the liquid immersion container 5 are immersed. For example, each substrate is a substrate forming a server, and the substrates are arrayed at a predetermined interval. A plurality of electronic components such as a CPU, a power supply unit, a memory, a storage such as a hard disk or a solid state drive (SSD), and a communication unit which form the server are mounted on the substrate. These electronic components generate heat during an operation of the server, and are cooled by the cooling liquid.

In the present embodiment, two liquid immersion containers 5 are provided in parallel. However, the number of the liquid immersion containers 5 is not limited thereto, and three or more liquid immersion containers 5 may be provided in parallel.

The CDU 7 is an abbreviation for a coolant distribution unit (cooling water circulation device), and is a heat exchanger that exchanges heat between cooling water supplied from the free cooling device 3 and the cooling liquid supplied to the liquid immersion container 5.

In the present embodiment, two CDUs 7 are provided for each liquid immersion container 5, and a total of four CDUs 7 are provided. However, the number of the CDUs 7 is not limited thereto, and three or more CDUs 7 may be provided for the liquid immersion container 5.

A cooling liquid circulation system 9 in which the cooling liquid is circulated is provided between the CDU 7 and the liquid immersion container 5. One cooling liquid circulation system 9 is provided for each of the CDUs 7, and a total of four cooling liquid circulation systems 9 are provided in parallel in the present embodiment.

Each cooling liquid circulation system 9 includes a supply pipe 9a that supplies a cooling liquid from the CDU 7 to the liquid immersion container 5, a return pipe 9b that returns the cooling liquid from the liquid immersion container 5 to the CDU 7, an automatic opening-closing valve 9c provided in the supply pipe 9a, an automatic opening-closing valve 9d provided in the return pipe 9b, and a cooling liquid pump 9e that transports the cooling liquid. Operations of the automatic opening-closing valves 9c and 9d are controlled by a control unit (not shown). A rotation speed of the cooling liquid pump 9e is controlled by a control unit (not shown), the cooling liquid pump 9e has a variable flow rate.

The free cooling device 3 includes a plurality of radiators 11, a fan 13 provided in each radiator, a cooling water tank 15 that stores cooling water flowing out from each radiator 11, and a cooling water return tank 17 that returns the cooling water to each radiator 11.

For example, the radiator 11 is a fin-tube type heat exchanger, and cools the cooling water by exchanging heat with outside air. The outside air is supplied to the radiator 11 by the fan 13. The fan 13 has a variable rotation speed, and is controlled by a control unit.

The cooling water flowing out from each radiator 11 is fed to the cooling water tank 15 through each radiator outlet pipe 11a.

A radiator inlet pipe 11b that returns the cooling water to the radiator 11 is provided between the cooling water return tank 17 and each radiator 11. The radiator inlet pipe 11b is provided with a radiator pump 11c and an automatic opening-closing valve 11d. The flow rate of the radiator pump 11c is variable, and the pump 11c is controlled by the control unit. The automatic opening-closing valve 11d is controlled by a control unit.

The cooling water tank 15 is provided with a cooling water outlet pipe 16 that guides the cooling water to a branch header portion 10. The cooling water outlet pipe 16 is provided with an automatic opening-closing valve 16a and a cooling water pump 16b. The automatic opening-closing valve 16a is controlled by a control unit. The cooling water pump 16b has a variable flow rate, and is controlled by a control unit. In the present embodiment, two cooling water outlet pipes 16 are provided in parallel. In addition, three or more cooling water outlet pipes 16 may be provided in parallel.

The cooling water return tank 17 is provided with a cooling water inlet pipe 18 that returns the cooling water from the branch header portion 10. In the present embodiment, two cooling water inlet pipes 18 are provided in parallel. In addition, three or more cooling water inlet pipes 18 may be provided in parallel.

As described above, since two cooling water outlet pipes 16 and two cooling water inlet pipes 18 are provided in parallel, two cooling water circulation systems are provided.

The branch header portion 10 is provided between the free cooling device 3 and the CDU 7, and includes a pipe and an opening-closing valve for distributing the cooling water. The branch header portion 10 is integrated and disposed in a predetermined region.

The branch header portion 10 includes an inlet header 10a to which each cooling water outlet pipe 16 is connected. An automatic opening-closing valve 10b controlled by a control unit is provided at a position where each cooling water outlet pipe 16 is connected. A plurality of branch supply pipes 10c are connected to the inlet header 10a. Each branch supply pipe 10c supplies the cooling water to the corresponding CDU 7. An automatic opening-closing valve 10d controlled by a control unit is provided in each branch supply pipe 10c. In FIG. 1, reference numerals A-1, A-2, and A-3 shown in the branch supply pipe 10c correspond to reference numerals A-1, A-2, and A-3 on an inlet side shown in each CDU 7.

The branch header portion 10 includes an outlet header 10f to which each cooling water inlet pipe 18 is connected. An automatic opening-closing valve 10g controlled by a control unit is provided at a position where each cooling water inlet pipe 18 is connected. A plurality of branch return pipes 10h are connected to the outlet header 10f. The cooling water is guided from the corresponding CDU 7 to each branch return pipe 10h. An automatic opening-closing valve 10i controlled by a control unit is provided in each branch return pipe 10h. In FIG. 1, reference numerals B-1, B-2, and B-3 shown in the branch return pipe 10h correspond to reference numerals B-1, B-2, and B-3 on an outlet side shown in each CDU 7.

The liquid immersion cooling device 1 includes an outside air temperature sensor 20 that measures an outside air temperature around the liquid immersion cooling device 1. An output of the outside air temperature sensor 20 is transmitted to a control unit. The control unit may acquire a temperature of a room in which the liquid immersion cooling device 1 is disposed, without providing the outside air temperature sensor 20.

The control unit is configured to acquire a calorific value generated by electronic equipment such as a server to be accommodated in the liquid immersion container 5. For example, the calorific value of the electronic equipment can be acquired from a higher-level control system.

In addition, for example, the control unit includes a central processing unit (CPU), a random access memory (RAM), a read only memory (ROM), a computer-readable storage medium, and the like. As an example, a series of processes for realizing various functions are stored in a storage medium in a form of a program. The CPU reads the program in the RAM or the like, and executes information processing and arithmetic processing. In this manner, various functions are realized. The program may adopt a form in which the program is installed in advance in the ROM or another storage medium, a form in which the program is provided in a stored state in a computer-readable storage medium, a form in which the program is delivered via wired or wireless communication means, or the like. The computer-readable storage medium is a magnetic disc, a magneto-optical disc, a CD-ROM, a DVD-ROM, a semiconductor memory, or the like.

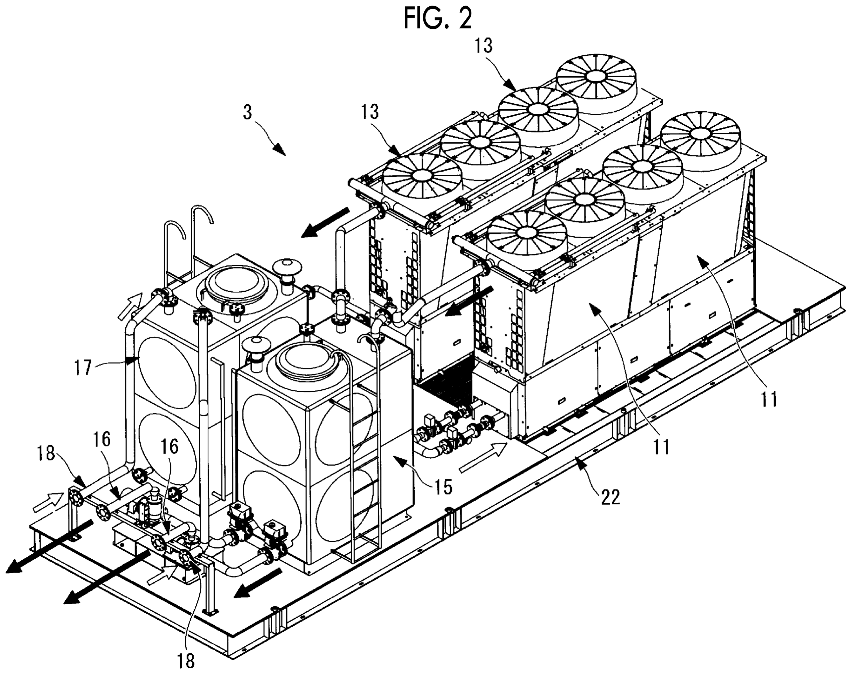

FIG. 2 shows a state where the free cooling device 3 is provided in a common installation panel 22. As shown in the drawing, the free cooling device 3, that is, the radiator 11, the fan 13, the cooling water tank 15, the cooling water return tank 17, the cooling water outlet pipe 16, the cooling water inlet pipe 18, and the like are installed on the installation panel 22 having a plate shape. Although not shown, a pure water manufacturing device may be provided in the common installation panel 22.

Next, a control method of the control unit will be described. The control unit sets a temperature of the cooling liquid in the liquid immersion container 5 to a desired value by using map control.

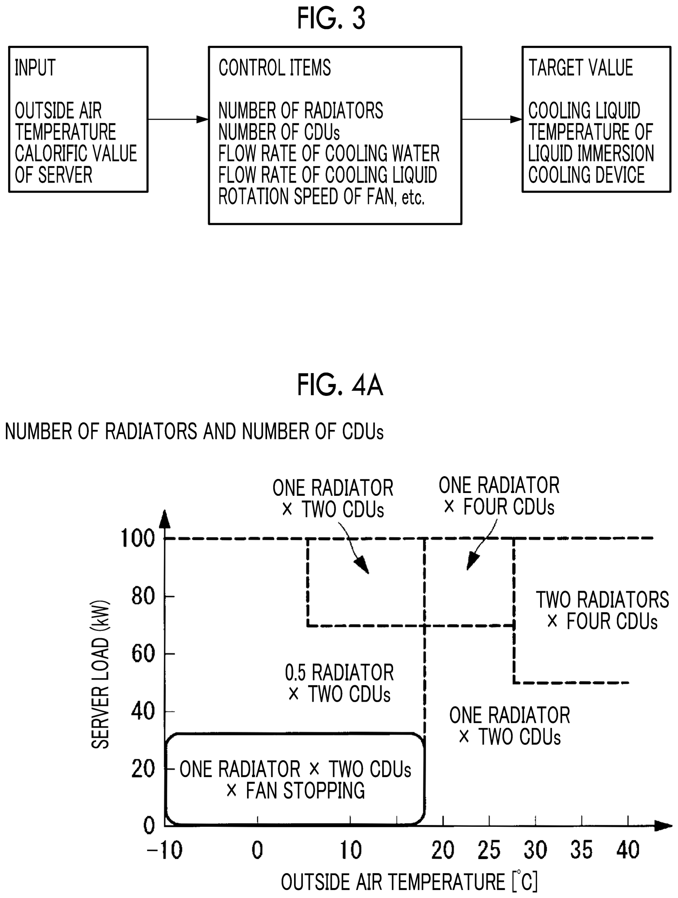

FIG. 3 shows an outline of the map control. In the map control, the outside air temperature around the liquid immersion cooling device 1 and the calorific value of the electronic equipment such as the server are used as input values. Control items are the number of the operating radiators 11, the number of the operating CDUs 7, a cooling water flow rate controlled by the cooling water pump 16b, a cooling liquid flow rate controlled by the cooling liquid pump 9e, a rotation speed of the fan 13, and the like. A control target value is the cooling liquid temperature of the liquid immersion container 5 that cools the electronic equipment. However, a desired value of the cooling liquid temperature is managed within a certain temperature range (for example, a temperature range of several °C). The control unit obtains the outside air temperature from the outside air temperature sensor 20 and the calorific value of the electronic equipment, which are current values, and controls an operation state of each device by using a control map described below.

FIG. 4A shows a control map of the number of the radiators 11 and the number of the CDUs 7. The control map is created in which a horizontal axis represents the outside air temperature (°C) and a vertical axis represents a server load (kW), which is the calorific value of the electronic equipment. The control map is stored in a storage unit of the control unit. As shown in the drawing, when the outside air temperature is low and the server load is small, only one of the two radiators 11 is operated, and the fan 13 is stopped. Only two of the four CDUs 7 are operated.

As the outside air temperature increases and the server load also increases, the control map is shifted to increase the number of the radiators 11 and the number of the CDUs 7.

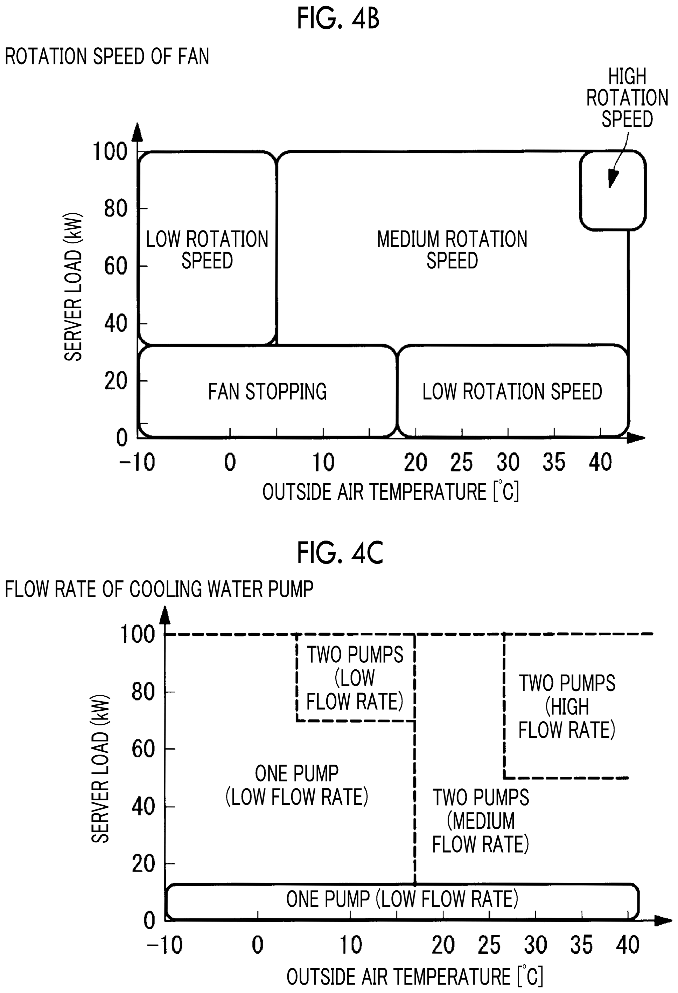

FIG. 4B shows the control map of the rotation speed of the fan 13. The rotation speed of the fan 13 is proportional to a blowing air flow rate. The vertical axis and the horizontal axis are the same as those in FIG. 4A. As shown in the drawing, when the outside air temperature is low and the server load is small, the fan 13 is stopped and air is not blown. As the outside air temperature increases and the server load increases, the control map is shifted to increase the blowing air flow rate by increasing the rotation speed of the fan 13.

FIG. 4C shows the control map of the flow rate of the cooling water pump 16b. The vertical axis and the horizontal axis are the same as those in FIG. 4A. As shown in the drawing, when the server load is small, the flow rate (rotation speed) is reduced by using only one cooling water pump 16b regardless of the outside air temperature. In the drawing, "(low flow rate)" means that the flow rate per one cooling water pump 16b is "low" when the flow rate is divided into three stages of high, medium, and low. The same applies to the interpretation of a "medium flow rate" and a "high flow rate".

When the server load increases, the control map is shifted to increase the number and the flow rates of the cooling water pumps 16b in accordance with the outside air temperature.

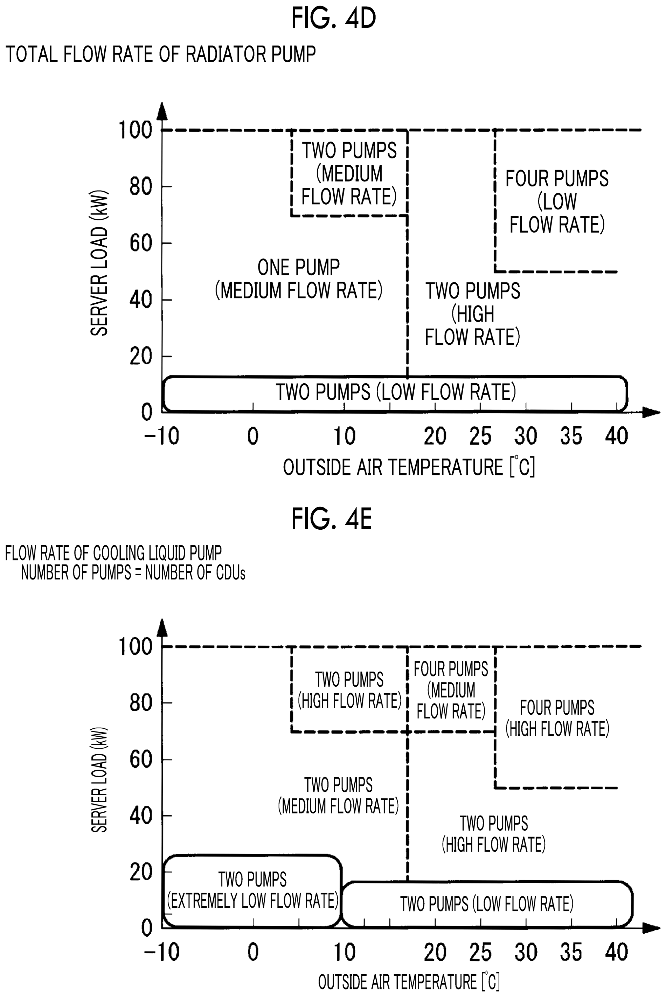

FIG. 4D shows the control map of the flow rate of the radiator pump 11c. The vertical axis and the horizontal axis are the same as those in FIG. 4A. When the outside air temperature and the server load increase, the control map is shifted to increase a total flow rate, that is, to increase the number and the flow rate of the radiator pumps 11c to be used. In the drawing, the interpretation of the "low flow rate", the "medium flow rate", and the "high flow rate" are the same as the interpretation in FIG. 4D.

FIG. 4E shows the control map of the flow rate of the cooling liquid pump 9e. The vertical axis and the horizontal axis are the same as those in FIG. 4A. Since the cooling liquid pump 9e is provided for each of the CDUs 7, the number of the cooling liquid pumps 9e to be used coincides with the number of the CDUs 7 to be used. When the outside air temperature and the server load increase, the control map is shifted to increase the number and the flow rates of the cooling liquid pumps 9e. In the drawing, the interpretation of the "low flow rate", the "medium flow rate", and the "high flow rate" are the same as the interpretation in FIG. 4D. However, a "minimum flow rate" means that the flow rate is lower than the "low flow rate".

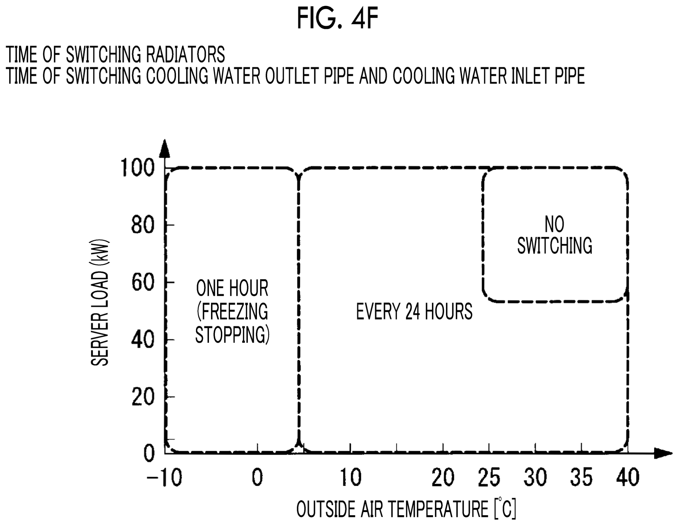

FIG. 4F shows the control map of a switching time of the radiator 11 and a switching time of the cooling water outlet pipe 16 and the cooling water inlet pipe 18. The vertical axis and the horizontal axis are the same as those in FIG. 4A.

As shown in the drawing, since there is a possibility of freezing when the outside air temperature is 5°C or lower, the switching time is set to 1 hour. Specifically, a time for using the radiator 11 is set to 1 hour, supply of the cooling water to the radiator 11 continuously used for 1 hour is stopped by the control unit, and the cooling water is supplied to the radiator 11 which is not used so far. Switching of the cooling water outlet pipe 16 and the cooling water inlet pipe 18 are similarly performed in accordance with an instruction of the control unit. The switching is performed in such a manner that the control unit appropriately operates the automatic opening-closing valve. When the outside air temperature is 5°C or higher and there is no possibility of freezing, the switching is performed every 24 hours. The reason is to extend a service life by causing the frequency of use to be uniform. However, when the outside air temperature is high (25°C or higher) and the server load is large, the switching is not performed. The reason is to prioritize the cooling of the server.

Operational effects of the present embodiment described above are as follows.

Four radiators 11 are provided in parallel, four CDUs 7 are provided in parallel, two cooling water circulation systems including the cooling water inlet pipe 18 and the cooling water inlet pipe 18 are provided in parallel, two liquid immersion containers 5 are provided in parallel, and four cooling liquid circulation systems 9 are provided in parallel. In this manner, the cooling system can have redundancy, and even when equipment troubles occur, a configuration can be adopted in which cooling is continued and the electronic equipment such as the server is not stopped.

Since the branch header portion 10 including the plurality of automatic opening-closing valves 10b, 10d, 10g, and 10i is integrated in the predetermined region, it is easier to check and monitor states of the automatic opening-closing valves 10b, 10d, 10g, and 10i, compared to when the switching valves are dispersed and disposed. In addition, the branch header portion 10 can be integrally transported, and a time required for pipe construction at a site can be shortened.

Since the number of the CDUs 7 to be used is switched, a heat transfer area of the heat exchanger can be adjusted. The temperature of the cooling liquid can be lowered even with the same PUE. For example, a cooling speed can be improved when emergency cooling is required at the time of a failure or the like.

Since the number of the radiators 11 to be used is switched, the heat transfer area of the heat exchanger can be adjusted. The temperature of the cooling liquid can be lowered even with the same PUE. For example, a cooling speed can be improved when emergency cooling is required at the time of a failure or the like.

With regard to the cooling water and a flow rate of the cooling water supplied to the CDU 7, the cooling water pump 16b and the cooling liquid pump 9e which adopt variable flow rates are used. In this manner, the number of flow rate adjustment valves can be reduced, and a probability of occurrence of equipment troubles can be reduced. In addition, a control method can be simplified, and the probability of occurrence of control troubles can be reduced.

The map control is performed to select an optimal operation of the cooling system in accordance with the calorific value (server load) of the electronic equipment and the outside air temperature. That is, the number of the radiators 11 to be used and the number of the CDUs 7 to be used are determined from two items of the calorific value of the electronic equipment and the outside air temperature. In this manner, adjustment parameters can be significantly reduced, a device configuration of the control system can be simplified, and the probability of occurrence of the control troubles can be reduced.

The free cooling device 3 is collectively installed in the common installation panel 22. In this manner, since those integrally provided in the common installation panel 22 can be transported, man-hours for site construction can be reduced. An installation location can be easily changed depending on a site situation.

In addition, the pure water manufacturing device may be provided in the common installation panel 22. In the heat exchanger using a copper pipe, using pure water is recommended from a viewpoint of corrosion. Although separately prepared normal pure water is used, since the pure water manufacturing device is provided in the common installation panel, a required amount of pure water can be supplied when necessary, and the pure water does not depend on water quality at the site.

The liquid immersion cooling device 1 described above is also applicable to a container-type data center accommodated in a container. In addition, the present invention is also applicable to a data center including an air cooling rack that cools the electronic equipment such as the server or a water cooling rack that cools electronic equipment such as the server.

The liquid immersion cooling device and the control method therefor which are described in each of the above-described embodiments are understood as follows, for example.

According to a first aspect of the present disclosure, there is provided a liquid immersion cooling device (1) including a radiator (11) that cools cooling water by exchanging heat with outside air, a liquid immersion heat exchanger (7) to which the cooling water cooled by the radiator is guided to exchange the heat with a cooling liquid, a cooling water circulation system in which the cooling water is circulated between the radiator and the liquid immersion heat exchanger, a liquid immersion container (5) to which the cooling liquid cooled by the liquid immersion heat exchanger is guided and in which the cooling liquid for immersing and cooling electronic equipment is stored, and a cooling liquid circulation system (9) in which the cooling liquid is circulated between the liquid immersion heat exchanger and the liquid immersion container. A plurality of the radiators, and/or a plurality of the liquid immersion heat exchangers, and/or a plurality of the cooling water circulation systems, and/or a plurality of the liquid immersion containers, and/or a plurality of the cooling liquid circulation systems are provided in parallel.

Since the plurality of radiators, the plurality of liquid immersion heat exchangers, and/or the plurality of cooling water circulation systems, and/or the plurality of liquid immersion containers, and/or the plurality of cooling liquid circulation systems are provided in parallel, the cooling system can have redundancy. In this manner, even when equipment troubles occur, a configuration can be adopted in which cooling is continued and the electronic equipment such as the server is not stopped.

As the liquid immersion cooling device according to a second aspect of the present disclosure, in the first aspect, the plurality of liquid immersion heat exchangers are provided in parallel, the cooling water circulation system includes a branch header portion (10) having switching valves (10d, 10i) that switch a flow to a cooling water pipe branched to each of the plurality of liquid immersion heat exchangers, and the branch header portion is integrated in a predetermined region.

Since the branch header portion including the switching valve is integrated in the predetermined region, it is easier to check and monitor states of the switching valves, compared to when the switching valves are dispersed and disposed. In addition, the branch header portion can be integrally transported, and a time required for pipe construction at a site can be shortened.

As the liquid immersion cooling device according to a third aspect of the present disclosure, the liquid immersion cooling device according to the first aspect or the second aspect further includes a control unit that controls the number of liquid immersion heat exchangers to be simultaneously used. The plurality of liquid immersion heat exchangers are provided in parallel.

Since the number of the liquid immersion heat exchangers to be used is switched, the heat transfer area of the heat exchanger can be adjusted. The temperature of the cooling liquid can be lowered even with the same PUE. For example, a cooling speed can be improved when emergency cooling is required at the time of a failure or the like.

As the liquid immersion cooling device according to a fourth aspect of the present disclosure, the liquid immersion cooling device according to any one of the first aspect to the third aspect further includes a control unit that controls the number of the radiators to be simultaneously used. The plurality of the radiators are provided in parallel.

Since the number of the radiators to be used is switched, the heat transfer area of the heat exchanger can be adjusted. The temperature of the cooling liquid can be lowered even with the same PUE. For example, a cooling speed can be improved when emergency cooling is required at the time of a failure or the like.

As the liquid immersion cooling device according to a fifth aspect of the present disclosure, in any one of the first aspect to the fourth aspect, the cooling water pump 16b provided in the cooling water circulation system and/or a cooling liquid pump 9e provided in the cooling liquid circulation system has a variable flow rate.

A pump having the variable flow rate is used for the cooling water and the flow rate of the cooling water supplied to the liquid immersion heat exchanger. In this manner, the number of flow rate adjustment valves can be reduced, and a probability of occurrence of equipment troubles can be reduced. In addition, a control method can be simplified, and the probability of occurrence of control troubles can be reduced.

According to a sixth aspect of the present disclosure, there is provided a liquid immersion cooling device (1) including a radiator (11) that cools cooling water by exchanging heat with outside air, a liquid immersion heat exchanger (7) to which the cooling water cooled by the radiator is guided to exchange the heat with a cooling liquid, a cooling water circulation system in which the cooling water is circulated between the radiator and the liquid immersion heat exchanger, a liquid immersion container (5) to which the cooling liquid cooled by the liquid immersion heat exchanger is guided and in which the cooling liquid for immersing and cooling electronic equipment is stored, and a cooling liquid circulation system (9) in which the cooling liquid is circulated between the liquid immersion heat exchanger and the liquid immersion container. A plurality of the radiators and a plurality of the liquid immersion heat exchangers are provided in parallel. The liquid immersion cooling device further includes a control unit that has a control map in which the number of the radiators to be used and the number of the liquid immersion heat exchangers to be used are represented on a map when an outside air temperature is set as a first axis and a calorific value of the electronic equipment to be cooled is set as a second axis, and that determines the number of the radiators to be used and the number of the liquid immersion heat exchangers to be used, from the control map, based on the outside air temperature and the calorific value of the electronic equipment during an operation.

Map control is performed to select an optimum operation of the cooling system in accordance with the calorific value of the electronic equipment and the outside air temperature. That is, the number of the radiators to be used and the number of the liquid immersion heat exchangers to be used are determined from two items of the calorific value of the electronic equipment and the outside air temperature. In this manner, adjustment parameters can be significantly reduced, a device configuration of the control system can be simplified, and the probability of occurrence of the control troubles can be reduced. It is preferable that the temperature of the cooling liquid of the liquid immersion cooling device serving as a target is managed within a prescribed range.

As the liquid immersion cooling device according to a seventh aspect of the present disclosure, the liquid immersion cooling device according to the sixth aspect further includes a fan (13) provided corresponding to each of the radiators, a plurality of radiator pumps (11c) provided corresponding to each of the radiators to supply the cooling water to the radiator, a plurality of cooling water pumps (16b) provided in the plurality of cooling water circulation systems, and a plurality of cooling liquid pumps (9e) provided in the plurality of cooling liquid circulation systems. The control unit has a control map in which an air volume of the fan and/or the number of the radiator pumps to be used and/or the number of the cooling water pumps to be used and/or the number of the cooling liquid pumps to be used are represented in a map. The control unit determines the air volume of the fan and/or the number of the radiator pumps to be used and/or the number of the cooling water pumps to be used and/or the number of the cooling liquid pumps to be used, from the control map, based on the outside air temperature and a calorific value of electronic equipment during an operation.

Furthermore, since the map control is performed on the radiator fan, the radiator pump, the cooling water pump, and the cooling liquid pump, controllability can be further improved.

As the liquid immersion cooling device according to an eighth aspect of the present disclosure, in any one of the first aspect to the seventh aspect, the radiator, a cooling water tank that stores the cooling water cooled by the radiator, and a cooling water return tank that stores the cooling water returned from the liquid immersion heat exchanger and stores the cooling water before being returned to the radiator are provided in a common installation panel (22).

Since those integrally provided in the common installation panel can be transported, man-hours for site construction can be reduced. An installation location can be easily changed depending on a site situation.

Furthermore, the radiator fan and the cooling water pump that supplies the cooling water may be provided in the common installation panel.

In addition, the pure water manufacturing device may be provided in the common installation panel. In the heat exchanger using a copper pipe, using pure water is recommended from a viewpoint of corrosion. Although separately prepared normal pure water is used, since the pure water manufacturing device is provided in the common installation panel, a required amount of pure water can be supplied when necessary, and the pure water does not depend on water quality at the site.

A control method for a liquid immersion cooling device according to a first aspect of the present disclosure includes a radiator that cools cooling water by exchanging heat with outside air, a liquid immersion heat exchanger to which the cooling water cooled by the radiator is guided to exchange the heat with a cooling liquid, a cooling water circulation system in which the cooling water is circulated between the radiator and the liquid immersion heat exchanger, a liquid immersion container to which the cooling liquid cooled by the liquid immersion heat exchanger is guided and in which the cooling liquid for immersing and cooling electronic equipment is stored, and a cooling liquid circulation system in which the cooling liquid is circulated between the liquid immersion heat exchanger and the liquid immersion container, in which a plurality of the radiators, and/or a plurality of the liquid immersion heat exchangers, and/or a plurality of the cooling water circulation systems, and/or a plurality of the liquid immersion containers, and/or a plurality of the cooling liquid circulation systems are provided in parallel. The control method includes switching the radiators, and/or the liquid immersion heat exchangers, and/or the cooling water circulation systems, and/or the liquid immersion containers, and/or the cooling liquid circulation systems.

According to a second aspect of the present disclosure, there is provided a control method for a liquid immersion cooling device including a radiator that cools cooling water by exchanging heat with outside air, a liquid immersion heat exchanger to which the cooling water cooled by the radiator is guided to exchange the heat with a cooling liquid, a cooling water circulation system in which the cooling water is circulated between the radiator and the liquid immersion heat exchanger, a liquid immersion container to which the cooling liquid cooled by the liquid immersion heat exchanger is guided and in which a cooling liquid for immersing and cooling electronic equipment is stored, and a cooling liquid circulation system in which the cooling liquid is circulated between the liquid immersion heat exchanger and the liquid immersion container, in which a plurality of the radiator and a plurality of the liquid immersion heat exchanger are provided in parallel. The control method includes preparing a control map in which the number of the radiators to be used and the number of the liquid immersion heat exchangersto be used are represented on a map when an outside air temperature is set as a first axis and a calorific value of the electronic equipment to be cooled is set as a second axis, and determining the number of the radiators in use and the number of the liquid immersion heat exchangers in use from the control map, based on the outside air temperature and the calorific value of the electronic equipment during an operation.

### Reference Signs List

1 liquid immersion cooling device
3: free cooling device
5: liquid immersion container
7 CDU (liquid immersion heat exchanger)
9: cooling liquid circulation system
9a: supply pipe
9b: return pipe
9c: automatic opening-closing valve
9d: automatic opening-closing valve
9e: cooling liquid pump
10: branch header portion
10a: inlet header
10b: automatic opening-closing valve
10c: branch supply pipe
10d: automatic opening-closing valve
10f: outlet header
10g: automatic opening-closing valve
10h: branch return pipe
10i: automatic opening-closing valve
11: radiator
11a: radiator outlet pipe
11b: radiator inlet pipe
11c: radiator pump
11d: automatic opening-closing valve
13: fan
15: cooling water tank
16: cooling water outlet pipe
16a: automatic opening-closing valve
16b: cooling water pump
17: cooling water return tank
18: cooling water inlet pipe
20: outside air temperature sensor

## Claims

1. A liquid immersion cooling device comprising:
a radiator that cools cooling water by exchanging heat with outside air;
a liquid immersion heat exchanger to which the cooling water cooled by the radiator is guided to exchange the heat with a cooling liquid;
a cooling water circulation system in which the cooling water is circulated between the radiator and the liquid immersion heat exchanger;
a liquid immersion container to which the cooling liquid cooled by the liquid immersion heat exchanger is guided and in which the cooling liquid for immersing and cooling electronic equipment is stored; and
a cooling liquid circulation system in which the cooling liquid is circulated between the liquid immersion heat exchanger and the liquid immersion container,
wherein a plurality of the radiators, and/or a plurality of the liquid immersion heat exchangers, and/or a plurality of the cooling water circulation systems, and/or a plurality of the liquid immersion containers, and/or a plurality of the cooling liquid circulation systems are provided in parallel.

2. The liquid immersion cooling device according to Claim 1,
wherein the plurality of liquid immersion heat exchangers are provided in parallel,
the cooling water circulation system includes a branch header portion having a switching valve that switches a flow to a cooling water pipe branched to each of the plurality of liquid immersion heat exchangers, and
the branch header portion is integrated in a predetermined region.

3. The liquid immersion cooling device according to Claim 1,
wherein the plurality of liquid immersion heat exchangers are provided in parallel, and
the liquid immersion cooling device further comprises a control unit that controls the number of the liquid immersion heat exchangers to be simultaneously used..

4. The liquid immersion cooling device according to Claim 1, further comprising:
wherein the plurality of radiators are provided in parallel, and
the liquid immersion cooling device further comprises a control unit that controls the number of the radiators to be simultaneously used.

5. The liquid immersion cooling device according to Claim 1,
wherein a cooling water pump provided in the cooling water circulation system and/or a cooling liquid pump provided in the cooling liquid circulation system has a variable flow rate.

6. A liquid immersion cooling device comprising:
a radiator that cools cooling water by exchanging heat with outside air;
a liquid immersion heat exchanger to which the cooling water cooled by the radiator is guided to exchange the heat with a cooling liquid;
a cooling water circulation system in which the cooling water is circulated between the radiator and the liquid immersion heat exchanger;
a liquid immersion container to which the cooling liquid cooled by the liquid immersion heat exchanger is guided and in which the cooling liquid for immersing and cooling electronic equipment is stored; and
a cooling liquid circulation system in which the cooling liquid is circulated between the liquid immersion heat exchanger and the liquid immersion container,
wherein a plurality of the radiators and a plurality of the liquid immersion heat exchangers are provided in parallel, and
the liquid immersion cooling device further comprises a control unit that has a control map in which the number of the radiators to be used and the number of the liquid immersion heat exchangers to be used are represented on a map when an outside air temperature is set as a first axis and a calorific value of the electronic equipment to be cooled is set as a second axis, and that determines the number of the radiators to be used and the number of the liquid immersion heat exchangers to be used, from the control map, based on the outside air temperature and the calorific value of the electronic equipment during an operation.

7. The liquid immersion cooling device according to Claim 6, further comprising:
a fan provided corresponding to each of the radiators;
a plurality of radiator pumps provided corresponding to each of the radiators to supply the cooling water to the radiators;
a plurality of cooling water pumps provided in a plurality of the cooling water circulation systems; and
a plurality of cooling liquid pumps provided in a plurality of the cooling liquid circulation systems,
wherein the control unit has the control map in which an air volume of the fan and/or the number of the radiator pumps to be used and/or the number of the cooling water pumps to be used and/or the number of the cooling liquid pumps to be used are represented on a map, and
the control unit determines the air volume of the fan and/or the number of the radiator pumps to be used and/or the number of the cooling water pumps to be used and/or the number of the cooling liquid pumps to be used, from the control map, based on the outside air temperature and a calorific value of electronic equipment during an operation.

8. The liquid immersion cooling device according to Claim 1,
wherein the radiator, a cooling water tank that stores the cooling water cooled by the radiator, and a cooling water return tank that stores the cooling water returned from the liquid immersion heat exchanger and stores the cooling water before being returned to the radiator are provided in a common installation panel.

9. A control method for a liquid immersion cooling device including
a radiator that cools cooling water by exchanging heat with outside air, a liquid immersion heat exchanger to which the cooling water cooled by the radiator is guided to exchange the heat with a cooling liquid,
a cooling water circulation system in which the cooling water is circulated between the radiator and the liquid immersion heat exchanger,
a liquid immersion container to which the cooling liquid cooled by the liquid immersion heat exchanger is guided and in which the cooling liquid for immersing and cooling electronic equipment is stored, and
a cooling liquid circulation system in which the cooling liquid is circulated between the liquid immersion heat exchanger and the liquid immersion container,
in which a plurality of the radiators, and/or a plurality of the liquid immersion heat exchangers, and/or a plurality of the cooling water circulation systems, and/or a plurality of the liquid immersion containers, and/or a plurality of the cooling liquid circulation systems are provided in parallel, the control method comprising:
switching between the radiators, and/or the liquid immersion heat exchangers, and/or the cooling water circulation systems, and/or the liquid immersion containers, and/or the cooling liquid circulation systems.

10. A control method for a liquid immersion cooling device including
a radiator that cools cooling water by exchanging heat with outside air, a liquid immersion heat exchanger to which the cooling water cooled by the radiator is guided to exchange the heat with a cooling liquid,
a cooling water circulation system in which the cooling water is circulated between the radiator and the liquid immersion heat exchanger,
a liquid immersion container to which the cooling liquid cooled by the liquid immersion heat exchanger is guided and in which the cooling liquid for immersing and cooling electronic equipment is stored, and
a cooling liquid circulation system in which the cooling liquid is circulated between the liquid immersion heat exchanger and the liquid immersion container,
in which a plurality of the radiators and a plurality of the liquid immersion heat exchangers are provided in parallel, the control method comprising:
preparing a control map in which the number of the radiators to be used and the number of the liquid immersion heat exchangers to be used are represented on a map when an outside air temperature is set as a first axis and a calorific value of the electronic equipment to be cooled is set as a second axis; and
determining the number of the radiators to be used and the number of the liquid immersion heat exchangers to be used, from the control map, based on the outside air temperature and the calorific value of the electronic equipment during an operation.
